(19) Europäisches Patentamt
European Patent Office
Office européen des brevets

(11) **EP 2 194 386 A2**

(12) **EUROPÄISCHE PATENTANMELDUNG**

(43) Veröffentlichungstag:
**09.06.2010 Patentblatt 2010/23**

(51) Int Cl.:
***G01R 19/00*** *(2006.01)*

(21) Anmeldenummer: **09169892.8**

(22) Anmeldetag: **10.09.2009**

(84) Benannte Vertragsstaaten:
**AT BE BG CH CY CZ DE DK EE ES FI FR GB GR
HR HU IE IS IT LI LT LU LV MC MK MT NL NO PL
PT RO SE SI SK SM TR**
Benannte Erstreckungsstaaten:
**AL BA RS**

(30) Priorität: **03.12.2008 AT 18852008**

(71) Anmelder: **Siemens AG Österreich
1210 Wien (AT)**

(72) Erfinder:
• **Hallak, Jalal
1220, Wien (AT)**
• **Schweigert, Harald
1120, Wien (AT)**

(74) Vertreter: **Maier, Daniel Oliver
Siemens Aktiengesellschaft
Postfach 22 16 34
80506 München (DE)**

(54) **Messverfahren zur Erfassung eines Drosselstromes**

(57) Die Erfindung betrifft ein Messverfahren, mittels dem ein Strom durch eine Drossel (SD) eines Schaltnetzteils erfasst wird, wobei die Drossel (SD) einen ohmschen Widerstand ($R_{SD}$) und eine Induktivität ($L_{SD}$) aufweist. Dabei ist die Drossel (SD) mit zumindest einem weiteren elektronischen Bauteil ($L_2$, C, R) gekoppelt und es wird eine an dem elektronischen Bauteil ($L_2$, C, R) anliegende Vergleichsspannung ($U_V$) oder die Differenzspannung ($\Delta U$) zwischen dieser Vergleichsspannung ($U_V$) und einer an der Drossel (SD) anliegenden Drosselspannung ($U_{SD}$) erfasst. Daraus wird die am ohmschen Widerstand ($R_{SD}$) der Drossel (SD) abfallende Spannung abgeleitet und in ein Verhältnis zum bekannten ohmschen Widerstand ($R_{SD}$) der Drossel (SD) gesetzt.

FIG 1

EP 2 194 386 A2

**Beschreibung**

Die Erfindung betrifft ein Messverfahren, mittels dem ein Strom durch eine Drossel eines Schaltnetzteils erfasst wird, wobei die Drossel einen ohmschen Widerstand und eine Induktivität aufweist.

Drosseln kommen in verschiedensten Typen von Schaltnetzteilen wie beispielsweise Tiefsetzer, Hochsetzer, CUK-Wandler, SEPIC-Wandler, Sperrwandler etc. als Speicherdrosseln oder Glättungsdrosseln zum Einsatz. Eine Drossel umfasst bekanntermaßen eine um einen Kern gewickelte Wicklung. Die von einem Strom durchflossene Wicklung weist dabei einen im Allgemeinen vernachlässigbaren ohmschen Widerstand auf.

Eine Drossel erfüllt in einem Schaltnetzteil die Funktion der Energiezwischenspeicherung während eines Taktes bzw. eine Glättungsfunktion. Ein Takt wird dabei durch das Ein- und Ausschalten eines Schaltelements oder mehrerer Schaltelemente bestimmt. Die Ansteuerung eines Schaltelements erfolgt über eine geeignete Steuerung, beispielweise gemäß einer Pulsweitenmodulation, wobei die Einschaltdauer die vom Schaltnetzteil übertragene Energie bestimmt. Die Ausgangsspannung eines Schaltnetzteils steht entweder als Gleichspannung oder im Falle eines Wechselrichters als Wechselspannung zur Verfügung. Als Wechselrichter gilt zum Beispiel ein Schaltnetzteil, das in einer ersten Stufe einen gepulsten Strom erzeugt, wobei die Polung dieses gepulsten Stromes mittels einer zweiten Stufe alternierend umgeschaltet wird. Alternativ dazu sind Wechselrichter bekannt, welche die Funktion zweiter Schaltnetzteil-Typen in einer Schaltung vereinigen. So kennt man beispielsweise aus der Offenlegungsschrift W02005/122371 ein als Wechselrichter ausgeführtes Schaltnetzteil, welches während einer positiven Halbwelle als Hoch-Tiefsetzsteller und während einer negativen Halbwelle als CUK-Wandler arbeitet.

Auf der Grundlage einer laufenden Erfassung des Drosselstromes werden die Ein- und Ausschaltzeitpunkte des Schaltelements bzw. der Schaltelemente festgelegt. Für die Steuerung eines Schaltnetzteils ist demnach eine Messung des durch die Drossel fließenden Stromes erforderlich. Bei Schaltnetzteilen, die als Wechselrichter betrieben werden ist zudem die Erfassung des Gleichstromanteils erforderlich, da nur sehr geringe Gleichstromkomponenten in ein angeschlossenes Netz oder einen nachgeschalteten Netztrafo eingespeist werden dürfen.

Nach dem Stand der Technik werden für die Messung eines Stromes durch eine Drossel eines Schaltnetzteils Stromwandler oder Shunt-Widerstände herangezogen. Shunt-Widerstände weisen den Nachteil einer oft nicht zu vernachlässigenden Verlustleistung auf, wenn ein Messsignal mit herkömmlichen Verstärkern aus dem Gesamtstrom herausgefiltert werden soll.

Eine Alternative bildet der Einsatz Gleichstrom messender Stromwandler. Dabei handelt es sich meist um Ringkerne, welche durch Kompensationswicklungen und Hallsensoren sowie Operationsverstärker immer auf einer Induktion gleich null gehalten werden. Der benötigte Kompensationsstrom dient als Messsignal. Derartige Wandler unterliegen jedoch thermischer Drift und erfordern bei hoher Präzision eine sehr aufwendige Konstruktion, vor allem, wenn Gleichströme kleiner 0,1% sicher und phasen- sowie amplitudenrichtig gemessen werden sollen.

Der Erfindung liegt die Aufgabe zugrunde, für ein Messverfahren der eingangs genannten Art eine Verbesserung gegenüber dem Stand der Technik anzugeben.

Erfindungsgemäß wird diese Aufgabe gelöst durch ein Verfahren gemäß Anspruch 1. Die Drossel ist dabei mit zumindest einem weiteren elektronischen Bauteil gekoppelt. Eine an dem elektronischen Bauteil anliegende Vergleichsspannung oder die Differenzspannung zwischen dieser Vergleichsspannung und einer an der Drossel anliegenden Drosselspannung wird erfasst und daraus wird die am ohmschen Widerstand der Drossel abfallende Spannung abgeleitet und in ein Verhältnis zum bekannten ohmschen Widerstand der Drossel gesetzt. Auf diese Weise erfolgt eine einfache Messung des Stromes in einer Drossel durch die Erfassung der Spannung am ohmschen Widerstand der Drossel in üblichen Schaltnetzteilen. Zudem ist es möglich, kleinste überlagerte Gleichstromkomponenten zu erfassen, was vor allem bei Wechselrichtern vorteilhaft ist. Die zu erkennenden Gleichstromanteile liegen im Bereich kleiner 0,1% des Wechselstromes.

Eine vorteilhafte Ausprägung der Erfindung sieht vor, dass das weitere elektronische Bauteil als eine Hilfsdrossel ausgebildet ist, welche die gleiche Induktivität wie die Drossel aufweist, dass die Wicklungen der Drossel und der Hilfsdrossel um einen gemeinsamen Kern gewickelt sind, dass die Wicklungsenden der beiden Drosseln miteinander verbunden sind. Die Drossel und die Hilfsdrossel sind also als sogenannte Kombidrossel ausgeführt.

Des Weiteren wird an den Wicklungsanfängen die Differenzspannung zwischen der an der Hilfsdrossel anliegenden Vergleichsspannung und der an der Drossel anliegenden Drosselspannung gemessen. Diese Differenzspannung wird dabei entweder floatend oder gegen eine Bezugsmasse gemessen.

Der durch die Drossel fließende Strom führt infolge des induktiven Widerstands der Drossel zu einem induktiven Spannungsabfall, darstellbar als induktiver Spannungsvektor, und infolge des ohmschen Widerstandes zu einem ohmschen Spannungsabfall, darstellbar als ohmscher Spannungsvektor. Eine Addition dieser beiden Vektoren ergibt den Spannungsvektor für die an der Drossel anliegende Drosselspannung. Durch die Hilfsdrossel fließt kein Strom, weshalb hier kein ohmscher Spannungsabfall auftritt. Der Wicklungsdraht der Hilfsdrossel ist deshalb auch deutlich dünner ausführbar als der Wicklungsdraht der Drossel.

Infolge der Kopplung der Hilfsdrossel und der Drossel sowie der übereinstimmenden Induktivität tritt an der Hilfsdrossel eine übereinstimmende induktive Spannung auf, darstellbar als zweiter induktiver Spannungsvektor mit gleichem Betrag wie der induktive Spannungsvektor der Drossel. Die Wicklungen sind dabei so angeordnet, dass sich die beiden induktiven Spannungsvektoren aufheben und die erfasste Differenzspannung dem Betrag des ohmschen Spannungsvektors entspricht. Es bleibt somit der ohmsche Spannungsabfall übrig, welcher unverzögert und phasenrichtig zur Verfügung steht. Anstelle eines bekannten Shunt-Widerstands wird der ohmsche Widerstand der Speicher- bzw. Glättungsdrossel zur Strommessung genutzt.

Dabei ist es von Vorteil, wenn die Wicklungen der Drossel und der Hilfsdrossel als eine doppeladrige (bifilare) Wicklung um den gemeinsamen Kern gewickelt sind. Auf diese Weiser wird eine besonders gute Kopplung erreicht, wobei eine Streuinduktivität zwischen den beiden Wicklungsadern vernachlässigbar ist.

Alternativ kann es auch sinnvoll sein, die Wicklungen der Drossel und der Hilfsdrossel als verschachtelte Wicklungen um den gemeinsamen Kern zu wickeln. Auch hier wird eine gute Kopplung mit vernachlässigbarer Streuinduktivität zwischen den beiden Wicklungen erreicht, wobei eine einfache Isolierung zwischen den Wicklungen zum Einsatz kommt.

Eine andere Ausprägung der Erfindung sieht vor, dass das weitere elektronische Bauteil als RC-Glied, bestehend aus einem Kondensator und einem in Reihe geschalteten Widerstand, ausgebildet ist, dass das RC-Glied parallel zu der Drossel angeordnet ist und dass als Vergleichsspannung die an dem Kondensator anliegende Spannung erfasst wird. Diese Kondensatorspannung korreliert mit dem Strom durch die Drossel, welcher sich aus einem Gleichstromanteil und einem Rippelanteil zusammensetzt. Der sich in der Kondensatorspannung abzeichnende Rippelanteil hängt dabei von den Werten des Widerstands und des Kondensators im Verhältnis zur Induktivität der Drossel ab.

Dabei ist es von Vorteil, wenn der Widerstand und der Kondensator in der Weise dimensioniert sind, dass das Verhältnis der Induktivität zum ohmschen Widerstandswert der Drossel dem Produkt aus dem Widerstandswert des Widerstands und der Kapazität des Kondensators entspricht. Die Relation des Rippelanteils zum Gleichanteil ist dann bei der gemessenen Kondensatorspannung dieselbe wie beim Drosselstrom. In diesem Fall ergibt sich der Drosselstrom in einfacher Weise aus der gemessenen Kondensatorspannung und dem bekannten ohmschen Widerstand der Drossel.

Ist hingegen das Verhältnis der Induktivität zum ohmschen Widerstandswert der Drossel kleiner als das genannte Produkt, dann erhält man ein an den Gleichanteil angenähertes Messergebnis. In umgekehrter Weise bildet das Messergebnis den Rippelanteil verstärkt ab, wenn das genannte Verhältnis größer als das genannte Produkt ist.

Wird der absolute Drosselstrom gemessen, ist es vorteilhaft, wenn die Wicklungstemperatur der Drossel erfasst wird und wenn bei einer Temperaturänderung die Änderung des ohmschen Widerstands der Drossel kompensiert wird. Das Ausmaß einer ohmschen Widerstandsänderung infolge einer Temperaturänderung ist zum Beispiel in einem Speicher abgespeichert oder wird in sonstiger Art einer entsprechenden Auswertelogik vorgegeben.

Die Erfindung wird nachfolgend in beispielhafter Weise unter Bezugnahme auf die beigefügten Figuren erläutert. Es zeigen in schematischer Darstellung:

Fig. 1      Schaltung mit Hilfsdrossel

Fig. 2      Zeitliche Verläufe des Drosselstromes und der erfassten Spannung bei einer Schaltung mit Hilfsdrossel

Fig. 3      Schaltung mit RC-Glied

Fig. 4-6    Zeitliche Verläufe des Drosselstromes und der erfassten Spannung bei einer Schaltung mit RC-Glied

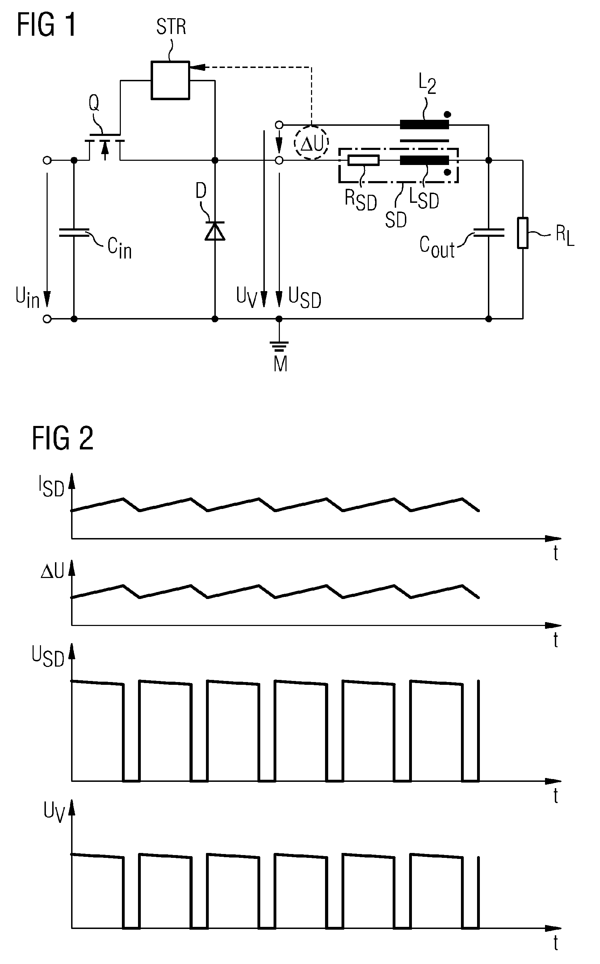

Ein Tiefsetzsteller ist ein einfaches Schaltnetzteil, weshalb er im Weiteren zur Beschreibung der verschiedenen Ausprägungen der Erfindung herangezogen wird. Damit ist keine Einschränkung der Erfindung verbunden, da das erfindungsgemäße Verfahren auch mittels Speicher- bzw. Glättungsdrosseln anderer Schaltnetzteiltypen ausführbar ist. Wie in Fig. 1 dargestellt, umfasst ein Tiefsetzsteller bekanntermaßen ein Schaltelement Q, eine Drossel SD und eine Diode D. In der Regel sind auch ein Eingangs- und ein Ausgangskondensator $C_{in}$, $C_{out}$ vorhanden. Das Schaltelement Q wird mittels einer Steuerung STR getaktet angesteuert. Der Tiefsetzsteller versorgt eine angeschlossene Last $R_L$ mit einer geringeren Spannung als die Eingangsspannung $U_{in}$.

Zur Bestimmung der Schaltzeitpunkte wird der Strom durch die Drossel SD erfasst, erfindungsgemäß mittels eines weiteren elektronischen Bauteils, welches mit der Drossel SD gekoppelt ist. In der in Fig. 1 dargestellten Ausprägung ist das weitere elektronische Bauteil als Hilfsdrossel $L_2$ ausgebildet. Die Wicklung der Hilfsdrossel $L_2$ ist mit der Wicklung der Drossel SD um denselben Kern gewickelt und weist die gleiche Induktivität auf. Der Wickelsinn ist bei beiden Wicklungen gleich, wie in Fig. 1 durch Punkte an den Wicklungsenden dargestellt. Dabei sind nur die Wicklungsenden der beiden Drosseln SD, $L_2$ verbunden. An den nicht verbundenen Wicklungsanfängen wird eine Differenzspannung $\Delta U$ abgegriffen.

Ist das Schaltelement Q eingeschaltet, fließt ein Strom vom positiven Pol der Eingangsspannung $U_{in}$ durch die Wicklung der Drossel SD, vom Wicklungsanfang zum Wicklungsende, und in weiterer Folge durch die Last $R_L$ zurück zum negativen Pol der Eingangsspannung $U_{in}$. Dabei wirken in der Drossel SD die reine Induktivität $L_{SD}$ und der ohmsche Widerstand $R_{SD}$. An der Drossel SD fallen somit eine ohmsche und eine induktive Spannung ab. Eine Vektoraddition dieser beiden Spannungen ergibt die an der Drossel SD abfallende Drosselspannung.

An der mit der Drossel SD gekoppelte Hilfsdrossel $L_2$ liegt nur eine induktive Spannung an, weil durch die Hilfsdrossel $L_2$ kein Strom fließt. Ein ohmscher Widerstand der Hilfsdrossel $L_2$ bleibt ohne Wirkung.

Diese Anordnung der beiden Drosseln SD, $L_2$ führt dazu, dass die an den Wicklungsanfängen anliegende Differenzspannung $\Delta U$ dem ohmschen Spannungsabfall am ohmschen Widerstand $R_{SD}$ der Drossel SD entspricht. Die Differenzspannung $\Delta U$ ist der Steuerung STR zugeführt und gibt anhand des ohmschen Gesetzes den aktuellen Wert des Drosselstromes wieder, wobei der ohmsche Widerstandwert der Drossel SD bekannt ist. Eine höhere Genauigkeit wird durch die Erfassung der Drosseltemperatur und eine Anpassung des ohmschen Widerstandswertes an eine Temperaturänderung erreicht.

Die Erfassung der Differenzspannung wird entweder floatend oder anhand der an den Wicklungsanfängen anliegenden Spannungen $U_V$, $U_{SD}$ gegen eine Bezugsmasse M gemessen. Der Verlauf des Drosselstromes $I_{SD}$, der Differenzspannung $\Delta U$ und der auf die Bezugsmasse M bezogenen Spannungen $U_V$, $U_{SD}$ an den Wicklungsanfängen über der Zeit t ist in Fig. 2 dargestellt.

Die beiden oberen Diagramme stellen die korrelierenden Verläufe des Drosselstromes $I_{SD}$ und der Differenzspannung $\Delta U$ dar. Unterhalb sind die Diagramme der beiden Spannungen $U_V$, $U_{SD}$ an den Wicklungsanfängen dargestellt, wobei folgende Beziehung gilt:

$$(1) \quad \Delta U = U_{SD} - U_V$$

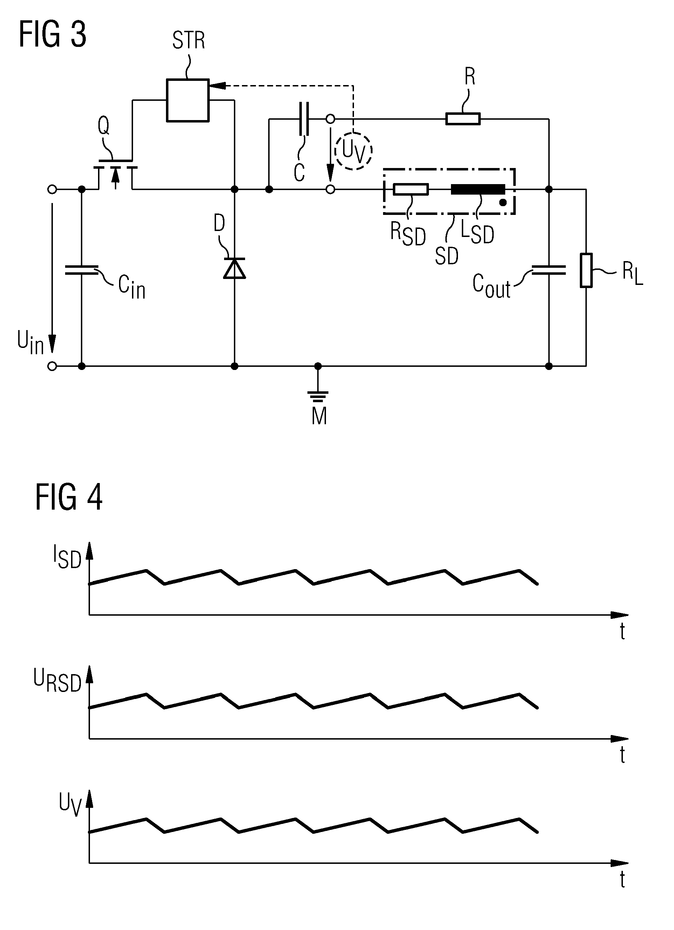

Eine andere Ausprägung der Erfindung ist in Fig. 3 dargestellt. Anstatt einer Hilfsdrossel ist parallel zu der Drossel SD des Tiefsetzstellers ein RC-Glied geschaltet und auf diese weise mit der Drossel SD gekoppelt. Das RC-Glied besteht aus einem Kondensator C und einem in Serie dazu angeordneten Widerstand R. Dabei gilt folgende Beziehung:

mit

| | |
|---|---|
| $I_0$ | Gleichstromanteil des Drosselstromes $I_{SD}$ |
| $I_\Delta$ | Rippelanteil des Drosselstromes $I_{SD}$ |
| $R_{SD}$ | ohmscher Widerstandswert der Drossel SD |
| $L_{SD}$ | Induktivität der Drossel SD |
| C | Kapazität des Kondensators C |
| R | Wert des Widerstands R |
| U | Spannungsabfall an der Drossel SD |
| $U_{RSD}$ | Spannungsabfall am ohmschen Widerstand der Drossel SD |
| $U_C$ | Spannungsabfall am Kondensator |
| $\omega$ | Kreisfrequenz des taktenden Schaltnetzteils |
| j | imaginäre Einheit |

$$(2) \quad U = I_0 * R_{SD} + I_\Delta * (R_{SD} + j * \omega * L_{SD})$$

$$(3) \quad U_C = U/(1 + j * \omega * R * C))$$

$$(4) \quad U_C = I_0 * R_{SD} + I_\Delta * R_{SD} * (1 + j * \omega * L_{SD}/R_{SD})/(1 + j * \omega * R * C)$$

Als Vergleichsspannung $U_V$ wird die Kondensatorspannung $U_C$ erfasst. Aus dem Gleichanteil dieser Spannung wird anhand des ohmschen Gesetzes mit dem ohmschen Widerstandswert $R_{SD}$ der Drossel SD der Gleichstromanteil $I_0$ des Drosselstromes $I_{SD}$ ermittelt.

Der Rippelanteil $I_\Delta$ des Drosselstromes $I_{SD}$ ist nur dann direkt über das ohmsche Gesetzt ermittelbar, wenn folgende Beziehung gilt:

$$(5) \quad R*C = L_{SD}/R_{SD}$$

In den Figuren 4 bis 6 sind die Verläufe des Drosselstromes $I_{SD}$, der am ohmschen Widerstand $R_{SD}$ der Drossel SD abfallenden Spannung $U_{RSD}$ und der Vergleichsspannung $U_V$ über der Zeit t dargestellt.

Wird die Beziehung (5) eingehalten, ergibt sich für die gemessene Vergleichsspannung $U_V$ und die am ohmschen Widerstand der Drossel SD abfallende Spannung $U_{RSD}$ der gleiche Verlauf. Beide Verläufe korrelieren dann unter Heranziehung des ohmschen Gesetzes mit dem Verlauf des Drosselstromes $I_{SD}$. Die Vergleichsspannung $U_V$, die der Steuerung STR zugeführt wird, bildet in diesem Fall direkt den Gleichstromanteil und der Rippelanteil des Drosselstromes $I_{SD}$ ab.

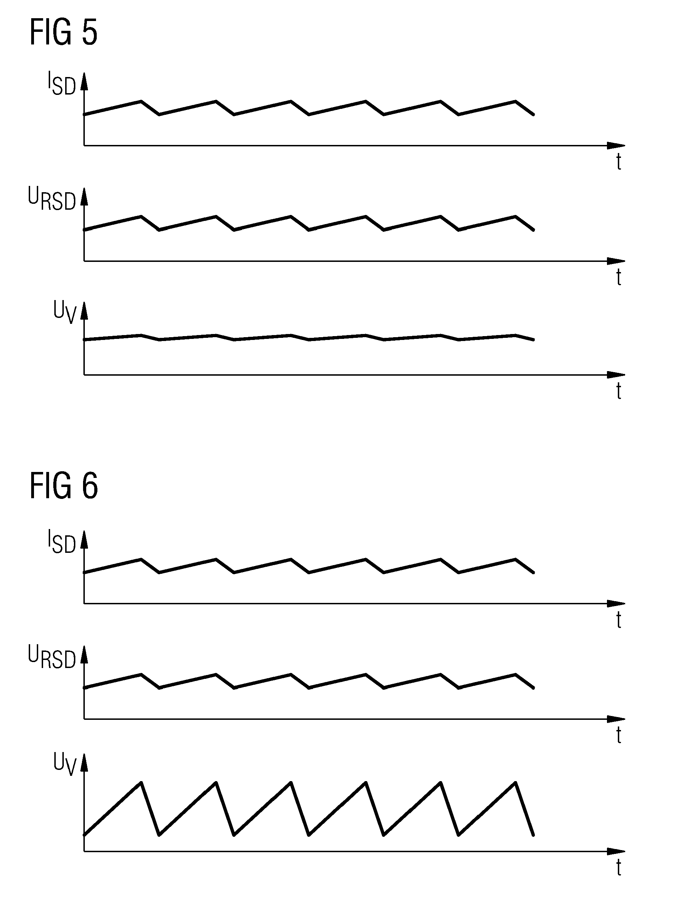

In Fig. 5 sind die Verläufe für den Fall dargestellt, dass die Beziehung $R*C > L_{SD}/R_{SD}$ gilt. Mit größer werdendem Produkt R*C sinkt der Rippelanteil der Vergleichsspannung $U_V$, sodass nur mehr der Gleichstromanteil des Drosselstromes $I_{SD}$ mit hinreichender Genauigkeit ermittelbar ist. Das ist vor allem bei Wechselrichtern ausreichend. Wie oben beschrieben soll bei einer Netzeinspeisung der Gleichstromanteil über eine Periodendauer der Netzschwingung gleich null sein. Daher reicht in diesem Fall die genaue Erfassung des Gleichstromanteils.

Der in Fig. 6 dargestellte Fall einer Beziehung $R*C < L_{SD}/R_{SD}$ führt zu einem verstärkten Rippelanteil der Vergleichsspannung $U_V$.

Auch andere Schaltungsvarianten, die eine Kopplung eines elektronischen Bauteils mit der Drossel SD vorsehen, eignen sich zur Durchführung des erfindungsgemäßen Verfahrens. Dabei kann, wie gezeigt, eine magnetische Kopplung oder eine Kopplung mittels eines Schwingungskreises zum Einsatz kommen. Die Relation einer erfassten Vergleichsspannung $U_V$ bzw. Differenzspannung $\Delta U$ zu der am ohmschen Widerstand $R_{SD}$ der Drossel SD abfallenden Spannung ist anhand der Beiteildimensionierung und der Art der Kopplung zu bestimmen.

**Patentansprüche**

1. Messverfahren, mittels dem ein Strom durch eine Drossel (SD) eines Schaltnetzteils erfasst wird, wobei die Drossel (SD) einen ohmschen Widerstand ($R_{SD}$) und eine Induktivität ($L_{SD}$) aufweist, **dadurch gekennzeichnet, dass** die Drossel (SD) mit zumindest einem weiteren elektronischen Bauteil ($L_2$, C, R) gekoppelt ist, dass eine an dem elektronischen Bauteil ($L_2$, C, R) anliegende Vergleichsspannung ($U_V$) oder die Differenzspannung ($\Delta U$) zwischen dieser Vergleichsspannung ($U_V$) und einer an der Drossel (SD) anliegenden Drosselspannung ($U_{SD}$) erfasst wird und dass daraus die am ohmschen Widerstand ($R_{SD}$) der Drossel (SD) abfallende Spannung abgeleitet und in ein Verhältnis zum bekannten ohmschen Widerstand ($R_{SD}$) der Drossel (SD) gesetzt wird.

2. Messverfahren nach Anspruch 1, **dadurch gekennzeichnet, dass** das weitere elektronische Bauteil als eine Hilfsdrossel ($L_2$) ausgebildet ist, welche die gleiche Induktivität wie die Drossel (SD) aufweist, dass die Wicklungen der Drossel (SD) und der Hilfsdrossel ($L_2$) um einen gemeinsamen Kern gewickelt sind, dass die Wicklungsenden der beiden Drosseln (SD, $L_2$) miteinander verbunden sind und dass an den Wicklungsanfängen die Differenzspannung ($\Delta U$) zwischen der an der Hilfsdrossel ($L_2$) anliegenden Vergleichsspannung ($U_V$) und der an der Drossel (SD) anliegenden Drosselspannung ($U_{SD}$) gemessen wird.

3. Messverfahren nach Anspruch 2, **dadurch gekennzeichnet, dass** die Wicklungen der Drossel (SD) und der Hilfsdrossel ($L_2$) als eine doppeladrige Wicklung um den gemeinsamen Kern gewickelt sind.

4. Messverfahren nach Anspruch 2, **dadurch gekennzeichnet, dass** die Wicklungen der Drossel (SD) und der Hilfsdrossel ($L_2$) als verschachtelte Wicklungen um den gemeinsamen Kern gewickelt sind.

5. Messverfahren nach Anspruch 1, **dadurch gekennzeichnet, dass** das weitere elektronische Bauteil als RC-Glied, bestehend aus einem Kondensator (C) und einem in Reihe geschalteten Widerstand (R), ausgebildet ist, dass das RC-Glied parallel zu der Drossel (SD) angeordnet ist und dass als Vergleichsspannung ($U_V$) die an dem Kondensator (C) anliegende Spannung erfasst wird.

6. Messverfahren nach Anspruch 5, **dadurch gekennzeichnet, dass** der Widerstand (R) und der Kondensator (C) in der Weise dimensioniert sind, dass das Verhältnis der Induktivität ($L_{SD}$) zum ohmschen Widerstandswert ($R_{SD}$) der Drossel (SD) dem Produkt aus dem Widerstandswert des Widerstands (R) und der Kapazität des Kondensators (C) entspricht.

7. Messverfahren nach einem der Ansprüche 1 bis 6, **dadurch gekennzeichnet, dass** die Wicklungstemperatur der Drossel (SD) erfasst wird und dass bei einer Temperaturänderung die Änderung des ohmschen Widerstands ($R_{SD}$) der Drossel (SD) kompensiert wird.

FIG 1

FIG 2

FIG 3

FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005122371 A